# EUROPEAN PATENT SPECIFICATION

(11) **EP 3 437 125 B1**
(45) Date of publication and mention of the grant of the patent: **26.06.2024**
(21) Application number: 17709889.4
(22) Date of filing: 27.02.2017
(51) Int. Cl.: H01L 21/82, H01P 3/08, H01P 11/00, H01L 21/66, H01L 21/20, H01L 21/768

(54) **METHODS FOR FORMING MICROSTRIP TRANSMISSION LINES ON THIN SILICON CARBIDE ON INSULATOR (SICOI) WAFERS**
VERFAHREN UND STRUKTUREN ZUR FORMUNG VON MIKROSTREIFENÜBERTRAGUNGSLEITUNGEN AUF DÜNNEN SILICIUMCARBID-AUF-ISOLATOR (SICOI)-WAFERN
PROCÉDÉS ET STRUCTURES POUR LA FORMATION DE LIGNES DE TRANSMISSION MICRORUBAN SUR DES TRANCHES CARBURE DE SILICIUM SUR ISOLANT (SICOI) MINCES

(30) Priority: 28.03.2016 US 201615082500
(43) Date of publication of application: 06.02.2019
(73) Proprietor: Raytheon Company, Waltham, MA 02451-1449 (US)
(72) Inventor: LAROCHE, Jeffrey R., Austin, Texas 78749 (US); IP, Kelly P., Lowell, Massachusetts 01852-1876 (US); KAZIOR, Thomas E., Sudbury, Massachusetts 01776 (US)
(74) Representative: Dentons UK and Middle East LLP
(86) International application number: PCT/US2017/019575
(87) International publication number: WO 2017/172154

(56) References cited:
- WO-A1-2015/088674
- US-A1- 2006 226 415
- US-A1- 2009 104 738

## Description

### CROSS REFERENCE TO RELATED APPLICATION

This application is a Continuation-In-Part of U. S. Patent Application 14/105,497 entitled METHODS AND STRUCTURES FOR FORMING MICROSTRIP TRANSMISSION LINES ON THIN SILICON ON INSULATOR (SOI) WAFERS, filed December 13, 2013, published as WO 2015/088674.

### TECHNICAL FIELD

This disclosure relates generally to semiconductor structures and manufacturing methods and more particular to methods and structures for forming microstrip transmission lines on thin Group III-V wafers, such as GaN on Silicon Carbide On Insulator (SOI) wafers.

### BACKGROUND

As is known in the art, it is sometimes desirable to form Group III-V devices on a substrate as a Monolithic Microwave Integrated Circuit (MMIC). One such substrate is silicon, as described in the above-referenced copending United States Patent Application serial no. 14/105,497, filed December 13, 2015, and other substrate is a silicon carbide (SiC) wafer, for example a four inch wafer of silicon carbide, having a thickness of about 400-500 microns, with a semiconductor layer of Group III-V material, such as GaN epitaxial layers formed on the upper surface using MOCVD or MBE.

As is also known in the art, microstrip transmission lines are sometimes used to interconnect active devices, such FET devices, and passive devices formed on, or in, the Group III-V layer. In one such case, after forming the FET and strip conductors of the microstrip transmission lines, the 400-500 micron thick SiC wafer must be thinned or polished to a thickness of 50-100 microns for the ground plane conductor microstrip transmission line which will be formed on the backside of the silicon carbide wafer; and, to accommodate conductive vias which pass through the silicon carbide wafer from the ground plane to electrodes of the FET. The process of thinning or polishing the backside of the wafer and formation of the vias from the backside of the wafer, however, are difficult to control. Further, the high cost of bulk SiC wafers acts as an impediment to wafer scaling (in the near term) as a 200 mm wafer will necessarily have to be thicker than a 150 mm wafer or 100 mm wafer in order to mitigate potential wafer breakage.

As is further known in the art, ohmic contacts are required in forming source and drain contacts for the FETs. To form these ohmic contacts, a rapid thermal anneal (RTA) process is used to anneal the contact metal to the semiconductor layer. The RTA process typical uses optical lamps to heat the surface of the wafer with the contact metal on the portions of the semiconductor layer where the ohmic contacts are formed. Because the SiC and GaN are optically clear (wide bandgap), absorption of the energy during rapid thermal anneal (RTA) of metal source and drain contacts becomes front mask/pattern dependent. This in turn leads to inconsistent ohmic contact results. Various approaches have been tried to deal with this issue. In one commonly used technique, the wafers are placed in a graphite susceptor which is heated by the lamps and the heat is absorbed by the susceptor is conductively transferred to the wafer to thereby heat the metal contact and form the requisite ohmic anneal. However, front mask/pattern dependent and generally inconsistent Ohmic contact results still often occur. Additionally, in volume production environments with large diameter wafers (e.g. 200 mm) susceptor use is impractical. WO2015/088674 relates to semiconductor structures and manufacturing methods and more particular to methods and structures for forming microstrip transmission lines on thin III-V, such as GaN on Silicon On Insulator (SOI) wafers in order to reduce wafer breakage and simplify via processing. US2006/226415A1 relates to a semiconductor integrated circuit device and a vehicle-mounted radar system using the same, and more particularly relates to a monolithic microwave integrated circuit (MMIC) device in which an active circuit and a passive circuit are monolithically integrated. US2009/0104738A1 relates to integrated circuits formed in semiconductor materials and in particular relates to methods for forming via openings in semiconductor substrates, Group III nitride epitaxial layers, and the resulting structures.

### SUMMARY

In accordance with the present invention a method is provided comprising: providing a structure having: (A) a silicon carbide layer and a first silicon dioxide layer over the silicon carbide layer ; and (B) a silicon layer and a second silicon dioxide layer over the silicon layer; the first silicon dioxide layer being bonded to the second silicon dioxide layer; wherein the first silicon dioxide layer and the second silicon dioxide layer provide a bonding structure. The first silicon dioxide layer is bonded to the second silicon dioxide layer and the upper surface of the silicon carbide layer is then polished to reduce its thickness. A Group III-V layer is formed on the upper surface of the thinned silicon carbide layer . A III-V device is formed in the Group III-V layer together with a strip conductor connected to the formed device. The silicon layer and the second silicon dioxide layer are successively removed to expose a bottom surface of the silicon carbide layer . A ground plane conductor is formed on the exposed bottom surface of the silicon carbide layer, the strip conductor, the ground plane conductor and a portion of the silicon carbide layer providing a portion of a microstrip transmission line, and Ohmic contacts are formed in a rapid thermal anneal process.

With such method and structure, a thinner silicon carbide wafer, and therefore less expensive silicon carbide wafer can be sliced from an ingot and the immediately bonded to the silicon handle. Further, by process the silicon wafer with the opaque silicon handle, the RTA process used to form Ohmic contacts is simplified by eliminating the need to use susceptors to suppress the effect of metal pattern density. The SiC wafer can be formed by sawing and polishing (for thicker layers ≥100µm) or by exfoliation for layers (<100µm).

The details of one or more embodiments of the disclosure are set forth in the accompanying drawings and the description below. Other features, objects, and advantages of the disclosure will be apparent from the description and drawings, and from the claims.

### DESCRIPTION OF DRAWINGS

FIGS. 1A-1H are diagrammatical cross-sectional sketches of a semiconductor structure at various stages in the fabrication according to the disclosure;
FIG. 2 is a flow chart of a process used to form the structure of FIGS. 1 A-1H in accordance with the disclosure;
FIGS. 3A-3H are diagrammatical cross-sectional sketches of a semiconductor structure at various stages in the fabrication according to another embodiment of the disclosure which does not form part of the claimed subject-matter; and
FIG. 4 is a flow chart of a process used to form the structure of FIGS. 3A-3H in accordance with the other embodiment of the disclosure.

Like reference symbols in the various drawings indicate like elements.

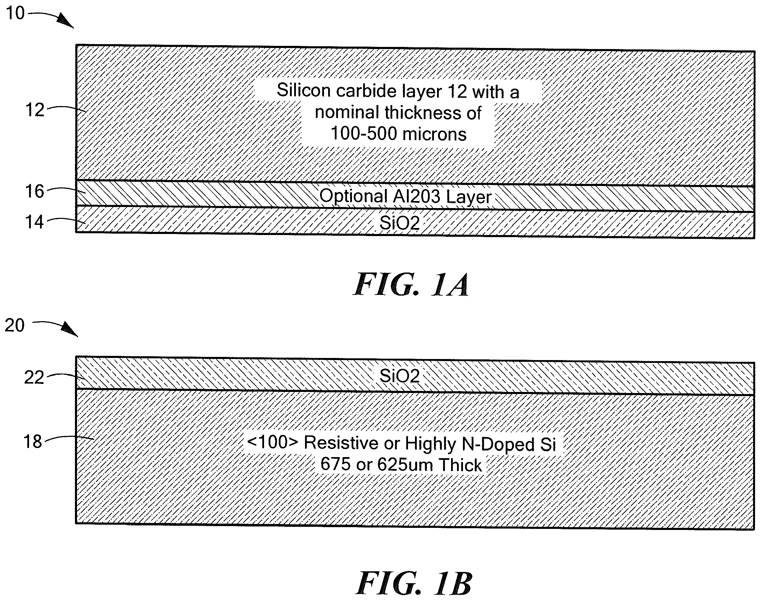

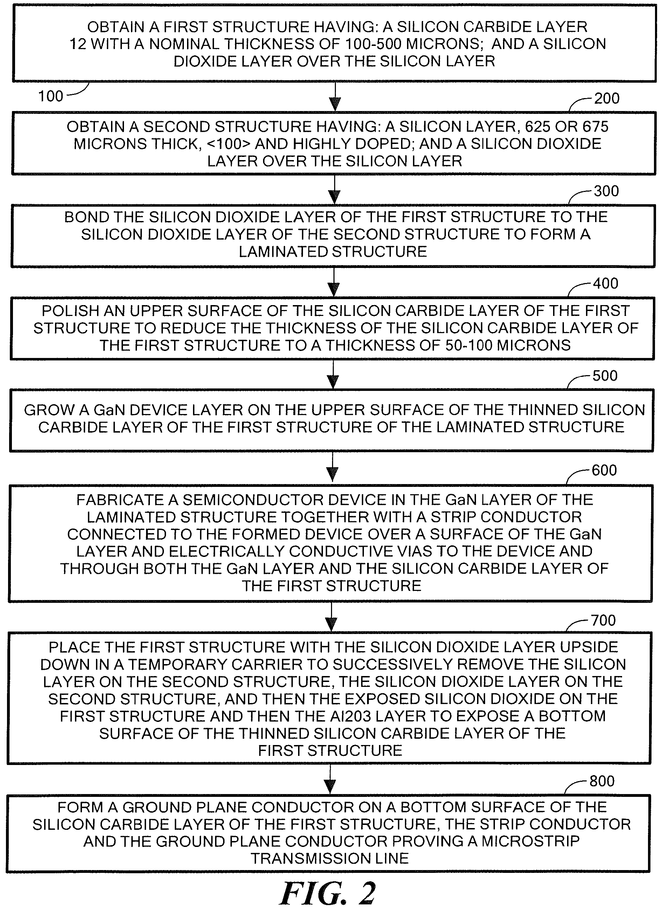

Referring now to FIGS. 1A and step 100 of FIG. 2, a first structure 10 is obtained having: a layer comprising silicon, here a silicon carbide layer 12 , here having a nominal thickness of 100-500 microns, with a silicon dioxide layer 14 over the silicon carbide layer 12. An optional etch stop layer 16, here for example, Al₂O₃ is may be disposed between the silicon dioxide layer 14 and the silicon carbide layer 12, as shown.

Referring now to FIG. 1B and step 200 of FIG. 2, a second structure 20 is obtained having: a silicon layer 18, here for example 625-675 microns thick, and a silicon dioxide layer 22 over the silicon layer 18.

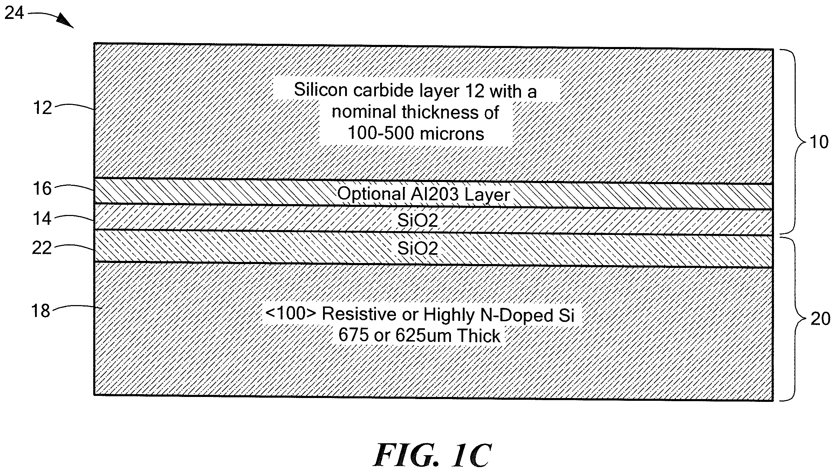

Referring now to FIG. 1C and step 300 of FIG. 2, the silicon dioxide layer 14 of the first structure 10 is bonded to the silicon dioxide layer 22 of the second structure 20 to form a laminated structure 24.

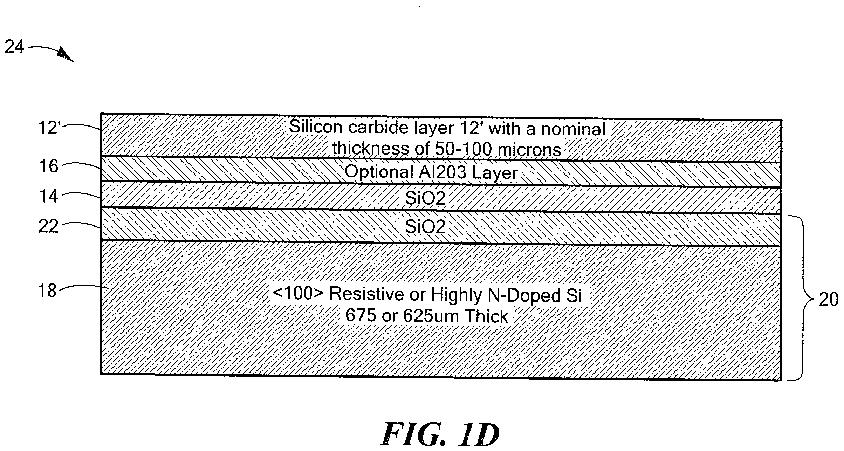

Referring now to FIG. 1D and step 400 of FIG. 2, the upper surface of the silicon carbide layer 12 (FIG. 1C) of the first structure is polished to reduce the layer to a thinner silicon carbide layer 12' (FIG. 1D), here to a thickness of 50-100 micron.

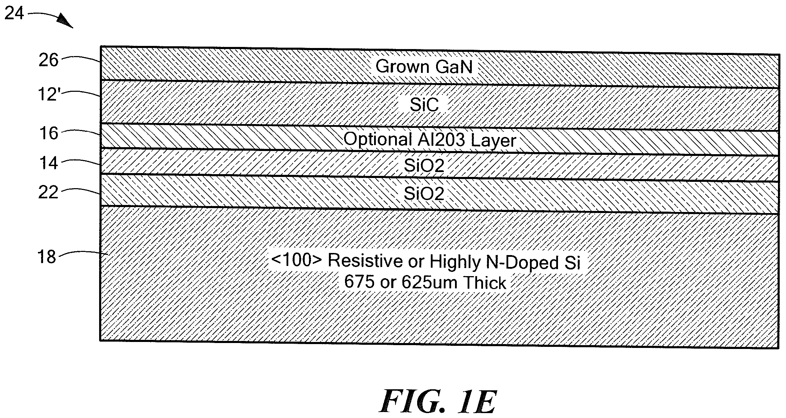

Next, referring to FIG. 1E and step 500 of FIG. 2, a layer 26 of Group III-V material, here for example, GaN, is grown on the upper surface of the thinned silicon carbide layer 12', by, for example, MOCVD or MBE.

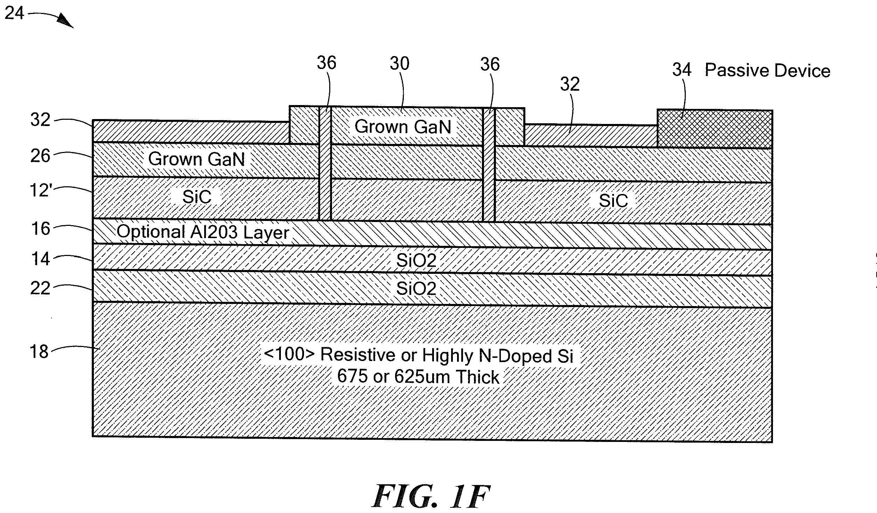

Next, referring to FIG. 1F and step 600 of FIG. 2, a Group III-V device 30, here for example, a GaN HEMT FET active device, is formed in the Group III-V layer 26 along with a strip conductors 32 connected to the device, 26 and a passive device 34 and an electrically conductive vias 36 to electrodes, such as the source electrode not shown of device 26 (it being noted that neither the gate electrode nor drain electrode is shown in FIG. 2) and vertically through the III-V layer 26 and through an underlying portion of the thinner silicon carbide layer 12' finally stopping at the interface of the thinner SiC (layer 12') and underlying dielectric which is either SiO₂ (layer 14) or the optional Al₂O₃ layer (layer 16).

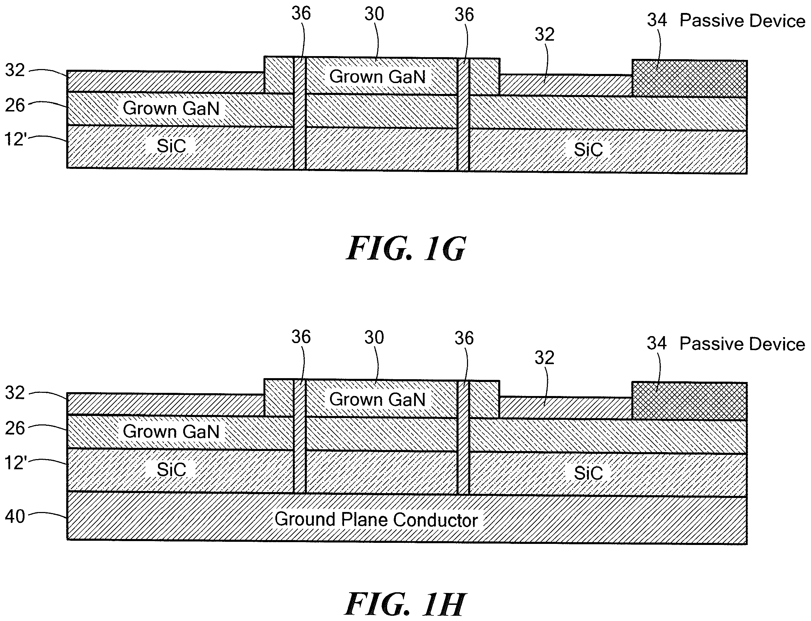

Next, the laminated structure shown in FIG. 1F and step 700 of FIG. 2, is placed upside down in a temporary carrier, not shown, to remove, as by polishing or etching, the silicon layer 18, and then the silicon dioxide layer 22, then the silicon dioxide layer 14 and finally the optional Al₂O₃ layer 16 (if present), to expose the bottom surface of the thinned silicon carbide layer 12'. The resulting structure is shown in FIG. 1G.

Next, referring to FIG. 1H and step 800 of FIG. 2, a ground plane conductor 40 is formed on a bottom surface of the thinned silicon carbide layer 12'; the strip conductor 32 and the ground plane conductor 40 providing a microstrip transmission line. The completed structure is in most cases then removed from the temporary carrier.

It should be understood that the second Si structure (layer 18) has been designated as 625-675µm thick (rather than the SEMI International Standards San Jose 3081 Zanker Road San Jose, CA 95134, USA conventional 725µm for 200mm wafers) in order to compensate for the 100-50µm the thickness of the first Si structure (layer 12). This is so that the overall thickness of the final bonded wafer stack will be close to the nominal 725µm SEMI standard thickness for 200mm wafers, and therefore avoid wafer handling issues in current, standard processing tools.

Ideally the thickness of the bonded silicon carbide (SiC) layer is the thinnest it can be in order to minimize the amount of expensive SiC needed in forming a SEMI Standard thickness (725µm thick) 200mm diameter wafer. Additionally, by limiting the post thinning silicon carbide thickness to 100-50µm (the thickness of the final Microstrip wafers) the amount of backside processing needed at foundries to facilitate microstrip devices is reduced. That is, the source vias can be etched and metallized from the front side. As a result, only minimal backside processing is needed to facilitate a high yield microstrip process. Furthermore, on insulator wafer fabrication facilities typically have superior control of their top bonded layer thicknesses. As a result, this prefabrication of the microstrip layer thickness at the wafer manufacturer will result in superior wafer thickness uniformity of the resultant microstrip devices fabricated at various foundries (since handle wafers and buried oxide can be removed selectively).

The Si handle wafer (silicon layer 18) also performs several vital functions. First, it provides the 625-675 microns thickness needed, in combination with silicon carbide layer 12' for the wafer reach a SEMI Standard thickness (725µm thick), so that it can be handled by standard tools at 200mm. Additionally, since silicon is not transparent, the Si handle wafer eliminates optical detection based wafer handling issues (during wafer transit in and out of tools). As a result, these wafers will not need to be backside metal coated in order to be detected by wafer handling systems. Finally, the silicon handle wafer (silicon layer 18), rapidly absorbs energy in the RTA processes used during Ohmic contact formation. As a result, control and repeatability of Ohmic contact are improved in the rapid thermal anneal (RTA) systems that are typically used in gallium nitride (GaN) processing. This is even more important at large wafer diameters and in volume production environments where susceptors are not typically used,

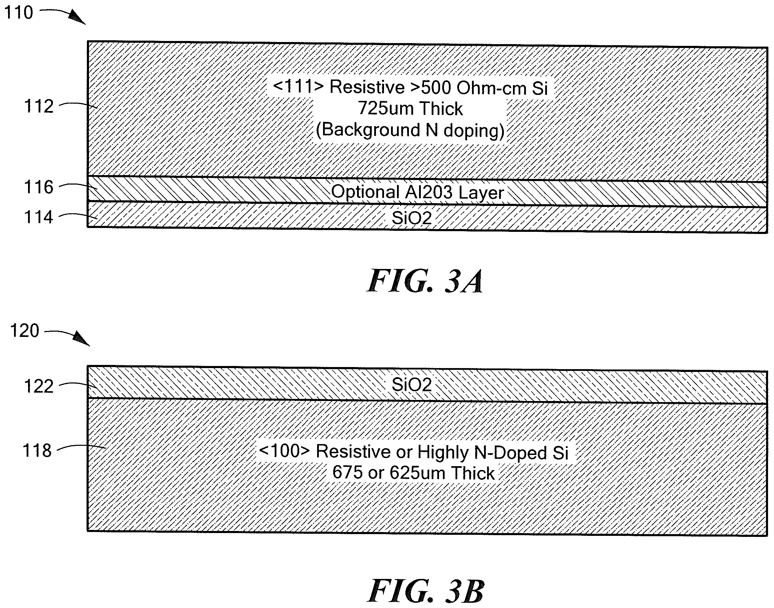

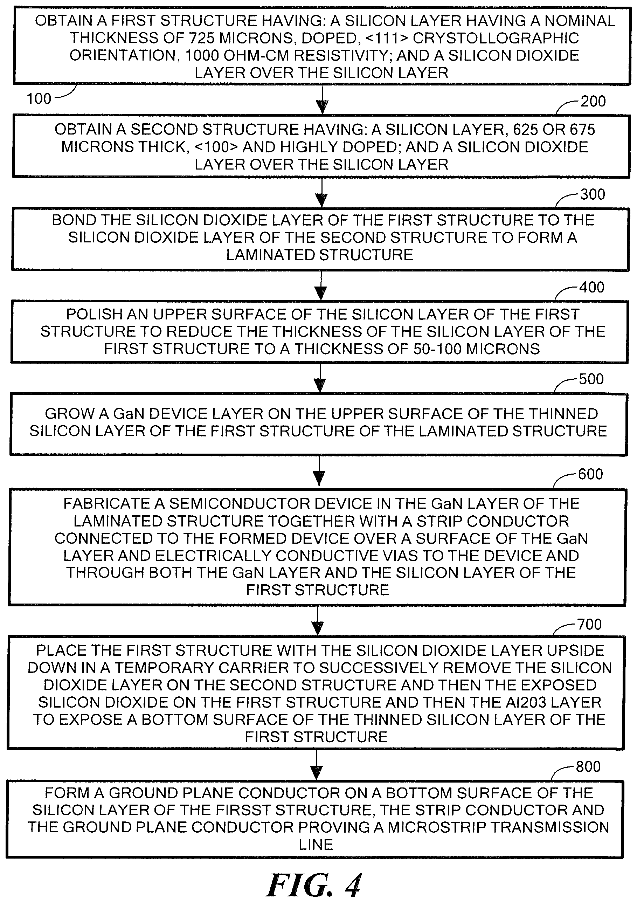

Referring now to FIGS. 3A and step 100 of FIG. 4, a first structure 110 is obtained having: a layer comprising silicon, here a silicon layer 112 having a <111> crystallographic orientation with a nominal thickness of 100-500 microns and lightly doped, preferably n-type, to have a resistivity >500 ohm-cm. A silicon dioxide layer 114 over the silicon layer 112. An optional etch stop layer 116, here for example, Al₂O₃ is may be disposed between the silicon dioxide layer 114 and the silicon layer 112, as shown.

Referring now to FIG. 3B and step 200 of FIG. 4, a second structure 120 is obtained having: a silicon layer 118, 625-675 microns thick, and more highly doped; and a silicon dioxide layer 122 over the silicon layer 118.

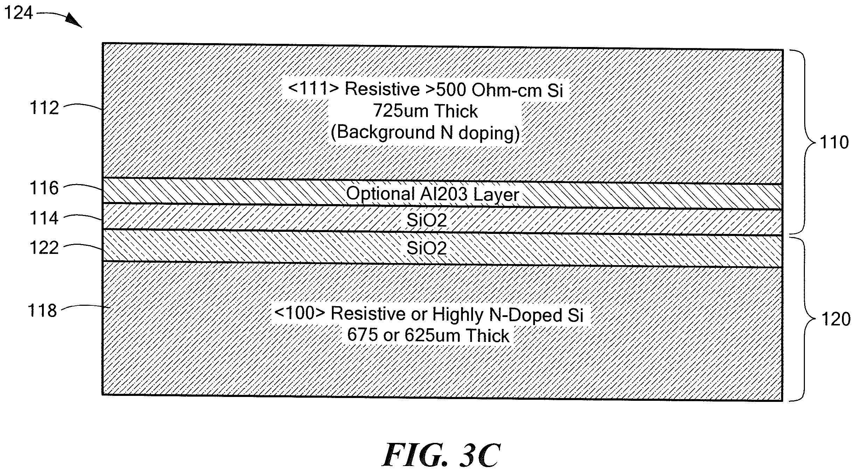

Referring now to FIG. 3C and step 300 of FIG. 4, the silicon dioxide layer 114 of the first structure 110 is bonded to the silicon dioxide layer 122 of the second structure 120 to form a laminated structure 124.

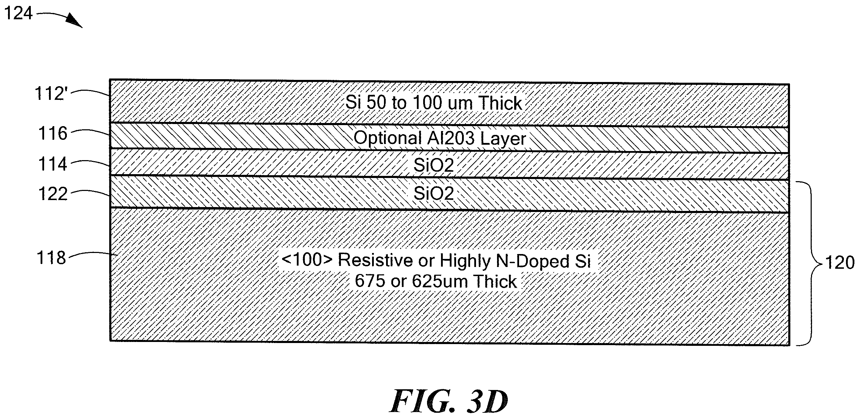

Referring now to FIG. 3D and step 400 of FIG. 4, the upper surface of the silicon layer 112 (FIG. 3C) of the first structure is polished to reduce the thickness of the silicon layer 112 to a thinner silicon layer 112' (FIG. 3D), here to a thickness of 50-100 micron.

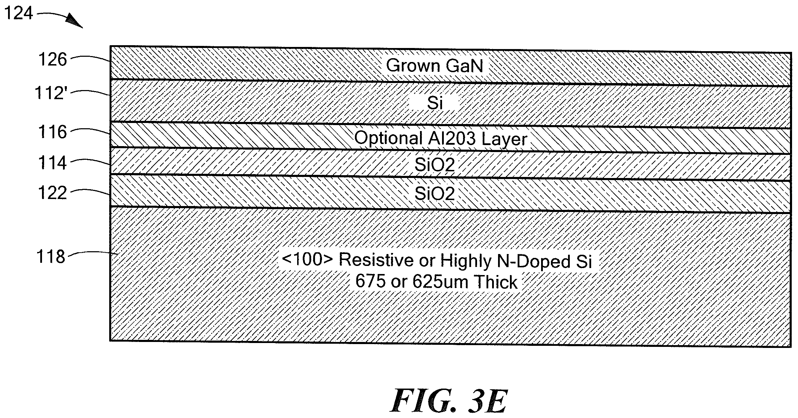

Next, referring to FIG. 3E and step 500 of FIG. 4, a layer 126 of Column III-V material, here for example, GaN, is grown on the upper surface of the thinned silicon layer 112', by, for example, MOCVD or MBE.

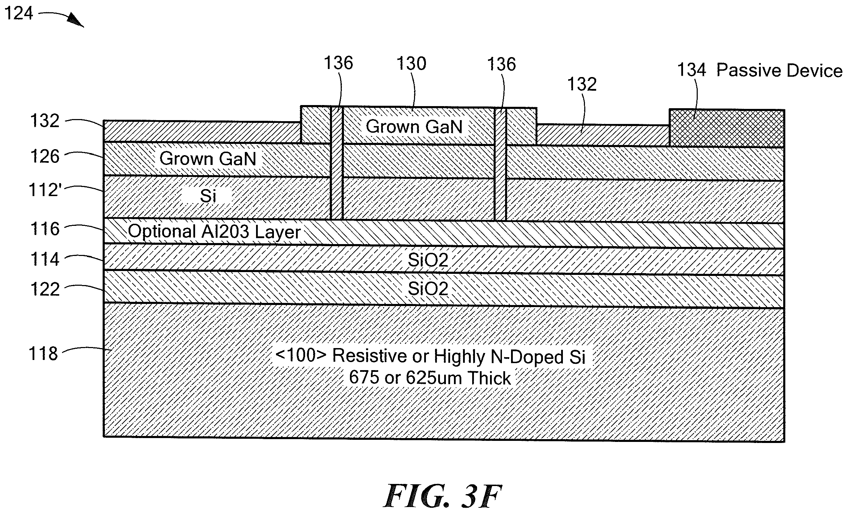

Next, referring to FIG. 3F and step 600 of FIG. 4, a III-V device 130, here for example, a GaN HEMT FET active device is formed in the III-V layer 126 along with a strip conductors 132 connected to the device, 126 and a passive device 134 and an electrically conductive vias 136 to electrodes, such as the source electrode not shown of device 126 (it being noted that neither the gate electrode nor drain electrode is shown in FIG. 3F) and vertically through the III-V layer 126 and through an underlying portion of the thinner silicon layer 112' finally stopping at the interface of the thinner Si (layer 112') and underlying dielectric which is either SiO₂ (layer 114) or the optional Al₂O₃ layer (layer1 16).

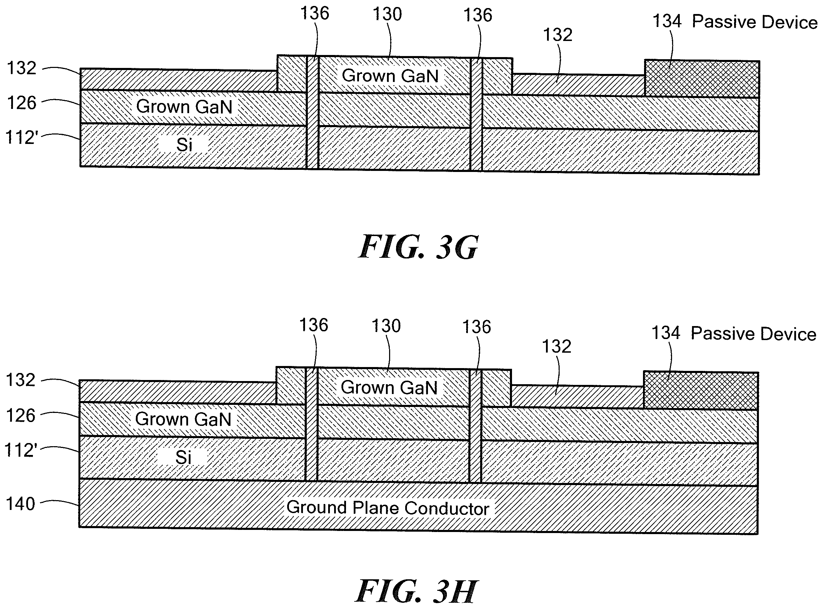

Next, the laminated structure shown in FIG. 3F and step 700 of FIG. 4, is placed upside down in a temporary carrier, not shown, to remove, as by polishing or etching, the silicon layer 118, and then the silicon dioxide layer 122, then the silicon dioxide layer 114 and finally the optional Al₂O₃ layer 116 (if present), to expose the bottom surface of the thinned silicon layer 112. The resulting structure is shown in FIG. 3G.

Next, referring to FIG. 3H and step 800 of FIG. 4, a ground plane conductor 140 is formed on a bottom surface of the thinned silicon layer 112'; the strip conductor 132 and the ground plane conductor 140 providing a microstrip transmission line. The completed structure is in most cases then removed from the temporary carrier.

It should now be appreciated a method according to the disclosure includes: (A) providing a structure having: layer comprising silicon; a bonding structure; and silicon layer, the bonding structure being disposed between the layer comprising silicon and the silicon layer, the silicon layer being thicker than the layer comprising silicon; and, a Group III-V layer disposed on an upper surface of the layer comprising silicon; (B) forming a Group III-V device in the III-V layer and a strip conductor connected to the device; (C) removing silicon layer and the bonding structure to expose a bottom surface of layer comprising silicon; and (D) forming a ground plane conductor on the exposed bottom surface of the layer comprising silicon to provide, with the strip conductor and the ground plane conductor, a microstrip transmission line.

The method may include one or more of the following features independently or in combination with another feature to include wherein the layer comprising silicon is <111> silicon or wherein the layer comprising silicon is silicon carbide.

It should now also be appreciated a method according to the disclosure includes providing a structure having: (A) a layer comprising silicon and a first silicon dioxide layer over the silicon carbide layer, and (B) a silicon layer and a second silicon dioxide layer over the silicon layer, the first silicon dioxide layer being bonded to the second silicon dioxide layer, wherein the first silicon dioxide layer and the second silicon dioxide layer provide a bonding structure; bonding the first silicon dioxide layer to the second silicon dioxide layer; growing a Group III-V layer on an upper surface of the layer comprising silicon; forming an active device in the Group III-V layer together with a strip conductor connected to the formed device; successively removing the silicon layer and the second silicon dioxide layer to expose a bottom surface of the layer comprising silicon; and forming a ground plane conductor is formed on the exposed bottom surface of the layer comprising silicon, the strip conductor, the ground plane conductor and a portion of the s layer comprising silicon providing a portion of a microstrip transmission line.

The method may include one or more of the following features independently or in combination with another feature to include: wherein the upper surface of the layer comprising silicon of the first structure is polished to reduce the thickness of the layer comprising silicon prior to forming the Group III-V layer; wherein the layer comprising silicon is <111> silicon; wherein the layer comprising silicon is silicon carbide; wherein the layer comprising silicon is silicon; or wherein Group III-V layer is formed on the upper surface of the layer comprising silicon before the bottom surface of the layer comprising silicon is polished to reduce its thickness.

A number of embodiments of the disclosure have been described. Nevertheless, it will be understood that various modifications may be made without departing from the spirit and scope of the disclosure. For example, all the oxide used in wafer bonding may be deposited or grown on either the first silicon carbide (SiC) structure (layer 12) or the Si structure (layer 18) and then bonded to the native oxide of the bare Si or SiC wafer respectively. Additionally, the thicknesses of the SiC layer, Si layer, and oxide layer can be changed from those described above and still fall within the spirit and scope of this disclosure. Still further, an additional thin Si layer (typically 1-2µm) may be bonded on top of the 50-100 um silicon or silicon carbide and thick 675-625µm Si substrate to form a tri-layer substrate that would allow CMOS processing and GaN growth in windows (exposed Si regions) and GaN device processing on the same substrate. This in turn would allow for heterogeneously integrated GaN/CMOS circuits. Further, the disclosure can be applied to other embodiments such as those described in FIG. 3 and FIGS. 4A-4K of the above-referenced continuation-in-part of copending United States Patent Application serial no. 14/105,497.

## Claims

1. A method, comprising:
providing a structure having: (A) a silicon carbide layer (12) and a first silicon dioxide layer (14) over the silicon carbide layer; and (B) a silicon layer (18) and a second silicon dioxide layer (22) over the silicon layer; bonding the first silicon dioxide layer to the second silicon dioxide layer; wherein the first silicon dioxide layer and the second silicon dioxide layer provide a bonding structure;
growing a Group III-V layer (26) on an upper surface of the silicon carbide layer;
forming an active device in the Group III-V layer together with a strip conductor (32) connected to the formed device;
successively removing the silicon layer and the first and second silicon dioxide layers to expose a bottom surface of the silicon carbide layer; and
forming a ground plane conductor (40) on the exposed bottom surface of the silicon carbide layer, the strip conductor, the ground plane conductor and a portion of the silicon carbide layer providing a portion of a microstrip transmission line; and wherein the method further comprises formation of Ohmic contacts in a rapid thermal anneal (RTA) process.

2. The method recited in claim 1 wherein the upper surface of the silicon carbide layer of the first structure is polished to reduce a thickness of the silicon carbide layer prior to forming the Group III-V layer.

3. The method recited in claim 1 wherein the Group III-V layer is formed on the upper surface of the silicon carbide layer before the bottom surface of the silicon carbide layer is polished to reduce its thickness.

## Patentansprüche

1. Verfahren, umfassend:
Bereitstellen einer Struktur, die Folgendes aufweist: (A) eine Siliciumcarbidschicht (12) und eine erste Siliciumdioxidschicht (14) über der Siliciumcarbidschicht; und (B) eine Siliciumschicht (18) und eine zweite Siliciumdioxidschicht (22) über der Siliciumschicht; Verbinden der ersten Siliciumdioxidschicht mit der zweiten Siliciumdioxidschicht; wobei die erste Siliciumdioxidschicht und die zweite Siliciumdioxidschicht eine Verbindungsstruktur bereitstellen;
Aufwachsen einer Gruppe-III-V-Schicht (26) auf einer oberen Oberfläche der Siliciumcarbidschicht;
Bilden einer aktiven Vorrichtung in der Gruppe-III-V-Schicht zusammen mit einem Streifenleiter (32), der mit der gebildeten Vorrichtung verbunden ist;
sukzessives Entfernen der Siliciumschicht und der ersten und zweiten Siliciumdioxidschicht, um eine untere Oberfläche der Siliciumcarbidschicht freizulegen; und
Bilden eines Grundflächenleiters (40) auf der freiliegenden unteren Oberfläche der Siliciumcarbidschicht, wobei der Streifenleiter, der Grundflächenleiter und ein Abschnitt der Siliciumcarbidschicht einen Abschnitt einer Mikrostreifenübertragungsleitung bereitstellen; und wobei das Verfahren ferner das Bilden von ohmschen Kontakten in einem Prozess der schnellen thermischen Ausglühung (RTA, rapid thermal anneal) umfasst.

2. Verfahren nach Anspruch 1, wobei die obere Oberfläche der Siliciumcarbidschicht der ersten Struktur poliert wird, um eine Stärke der Siliciumcarbidschicht zu reduzieren, bevor die Gruppe III-V-Schicht gebildet wird.

3. Verfahren nach Anspruch 1, wobei die Gruppe-III-V-Schicht auf der oberen Oberfläche der Siliciumcarbidschicht gebildet wird, bevor die untere Oberfläche der Siliciumcarbidschicht poliert wird, um ihre Stärke zu reduzieren.

## Revendications

1. Procédé, comprenant :
la fourniture d'une structure présentant : (A) une couche de carbure de silicium (12) et une première couche de dioxyde de silicium (14) sur la couche de carbure de silicium ; et (B) une couche de silicium (18) et une seconde couche de dioxyde de silicium (22) sur la couche de silicium ; la liaison de la première couche de dioxyde de silicium à la seconde couche de dioxyde de silicium ; dans lequel la première couche de dioxyde de silicium et la seconde couche de dioxyde de silicium fournissent une structure de liaison ;
la croissance d'une couche du groupe III-V (26) sur une surface supérieure de la couche de carbure de silicium ;
la formation d'un dispositif actif dans la couche du groupe III-V avec une bande conductrice (32) connectée au dispositif formé ;
le retrait successif de la couche de silicium et des première et seconde couches de dioxyde de silicium pour exposer une surface inférieure de la couche de carbure de silicium ; et
la formation d'un conducteur de plan de sol (40) sur la surface inférieure exposée de la couche de carbure de silicium, la bande conductrice, le conducteur de plan de sol et une partie de la couche de carbure de silicium fournissant une partie d'une ligne de transmission microruban ; et dans lequel le procédé comprend en outre la formation de contacts ohmiques dans un processus de recuit thermique rapide (RTA).

2. Procédé selon la revendication 1 dans lequel la surface supérieure de la couche de carbure de silicium de la première structure est polie pour réduire une épaisseur de la couche de carbure de silicium avant de former la couche du groupe III-V.

3. Procédé selon la revendication 1 dans lequel la couche du groupe III-V est formée sur la surface supérieure de la couche de carbure de silicium avant que la surface inférieure de la couche de carbure de silicium ne soit polie pour réduire son épaisseur.
